# EUROPÄISCHE PATENTSCHRIFT

(11) **EP 3 759 519 B1**
(45) Veröffentlichungstag und Bekanntmachung des Hinweises auf die Patenterteilung: **12.06.2024**
(21) Anmeldenummer: 19703668.4
(22) Anmeldetag: 04.02.2019
(51) Int. Cl.: G01S 17/93

(54) **KÜHLVORRICHTUNG**
COOLING DEVICE
DISPOSITIF DE REFROIDISSEMENT

(30) Priorität: 01.03.2018 DE 102018203075
(43) Veröffentlichungstag der Anmeldung: 06.01.2021
(73) Patentinhaber: Robert Bosch GmbH, 70442 Stuttgart (DE)
(72) Erfinder: OLIVEIRA, Joao, 4710-378 Braga (PT); COSTA, Joao, 4785-133 Trofa (PT); SANTOS, Joao, 3050-112 Barcouco (PT); HOLLECZEK, Annemarie, 71638 Ludwigsburg (DE)
(86) Internationale Anmeldenummer: PCT/EP2019/052579
(87) Internationale Veröffentlichungsnummer: WO 2019/166180

(56) Entgegenhaltungen:
- DE-A1-102004 035 741
- DE-A1-102017 104 988
- US-A1- 2010 157 531
- US-B1- 9 734 744

## Beschreibung

Die Erfindung betrifft eine Kühlvorrichtung, die insbesondere zur Kühlung eines Umfeldsensors eines Kraftfahrzeugs ausgebildet ist. Die Erfindung betrifft weiterhin ein Verfahren zur Kühlung eines wärmeabgebenden Geräts, insbesondere eines Umfeldsensors eines Kraftfahrzeugs, sowie ein Fahrzeug sowie einen Lidarsensor mit einer Kühlvorrichtung.

### Stand der Technik

Die US 4,884,631 offenbart eine Kühlvorrichtung, bei der ein Luftstrom entlang mehrerer Pfade durch eine Kühlstruktur geleitet wird. Die Kühlstruktur weist Kühlrippen oder Kühlwaben auf.

Die US 6,305,463 B1 offenbart eine Kühlvorrichtung für Leiterplattenmodule. Die Kühlvorrichtung weist einen flüssigkeitsgekühlten Abschnitt und einen luftgekühlten Abschnitt auf. Die Abschnitte sind unabhängig voneinander benutzbar und derart angeordnet, dass die Kühlvorrichtung für unterschiedliche Anwendungen genutzt werden kann, abhängig von der benötigten Kühlleistung einer bestimmten Anwendung. Es können auch sowohl der luftgekühlte Abschnitt als auch der flüssigkeitsgekühlte Abschnitt verwendet werden.

Die US 7,652,880 B2 beschreibt eine Kühlvorrichtung, bei der sowohl natürliche Konvektion als auch ein durch einen Lüfter erzeugter Luftstrom zur Kühlung verwendet wird. Die Kühlvorrichtung weist dazu einen Kühlkörper mit Kühlrippen und einer Vielzahl von Luftkanälen auf, sowie mindestens einen Lüfter auf.

Kühlvorrichtungen, die Kühlrippen aufweisen, sind üblicherweise darauf ausgelegt, entweder natürliche Konvektion, erzwungene Luftströmungen oder Kombinationen von beidem zur Kühlung zu verwenden.

Die DE 10 2017 104988 A1 offenbart eine Kühlvorrichtung, zumindest umfassend einen Gehäuserahmen, einen Wärmetauscher, eine elektrisch antreibbare Lüftereinheit, wobei die Lüftereinheit derart angeordnet ist, dass bei ihrem Betrieb ein erster Luftstrom in Richtung einer ersten Oberfläche der Wärmetauscher erzeugt wird. Zudem weist der Gehäuserahmen einen Luftkanal mit einer Lufteinlassöffnung und einer Luftauslassöffnung auf, wobei der Luftkanal parallel zu der ersten Oberfläche der Wärmetauscher ausgebildet ist.

Speziell beim Einsatz in einem Kraftfahrzeug sind jedoch Szenarien denkbar in denen zur ausreichenden Kühlung zusätzlich der externe, durch die Bewegung des Fahrzeugs erzeugte Luftstrom benötigt wird.

Ein Beispiel ist eine Sensoreinheit, z.B. ein Umfeldsensor des Fahrzeugs, die durch ihre Elektronik selbst Wärme produziert und gekühlt werden muss und die nahe am Motorraum des Fahrzeugs befestigt ist. Bei einem Verbrennungsmotor können in diesem Bereich Temperaturen von bis zu 140°C auftreten. Wenn aufgrund von Sonneneinstrahlung zusätzlich hohe Außentemperaturen vorliegen und das Fahrzeug bei laufendem Motor steht oder nur langsam vorankommt, zum Beispiel, wenn das Fahrzeug im Stau steht, reicht die Kühlung durch den externen Luftstrom (Fahrtwind) nicht mehr aus. Die Sensoreinheit muss den Betrieb einstellen um Beschädigungen durch Überhitzung der Elektronik oder der Sensorkomponenten zu vermeiden.

Der Einsatz einer Kühlvorrichtung gemäß dem Stand der Technik kann das Problem beheben, indem elektrisch angetriebene Lüfter verwendet werden, um auch dann Wärme durch Konvektion abzuführen, wenn kein externer Luftstrom vorhanden ist. Der Nachteil dieser Systeme besteht darin, dass die Lüfter im Dauerbetrieb laufen und Energie verbrauchen, auch in Situationen, wenn genug Fahrtwind vorhanden ist, um eine ausreichende Kühlung der Sensoreinheit zu gewährleisten.

### Offenbarung der Erfindung

Gemäß der vorliegenden Erfindung wird eine Kühlvorrichtung vorgeschlagen, die einen Gehäuserahmen, einen Wärmetauscher, eine elektrisch antreibbare Lüftereinheit, eine Kontrolleinheit und eine Sensoreinheit umfasst. Darüber hinaus kann die Kühlvorrichtung weitere, funktionale Einheiten wie beispielsweise Druckausgleichselemente, Anschlüsse, etc. enthalten. Der Gehäuserahmen kann dabei insbesondere auf einer ersten Oberfläche des Wärmetauschers angeordnet sein.

Die Lüftereinheit, z.B. ein Lüfter oder Ventilator, ist derart angeordnet, dass bei Betrieb der Lüftereinheit ein erster Luftstrom in Richtung der ersten Oberfläche des Wärmetauschers erzeugt wird. Die Lüftereinheit ist beispielsweise in einer Aussparung des Gehäuserahmens aufgenommen. Erfindungsgemäß weist der Gehäuserahmen mindestens einen Luftkanal mit einer Lufteinlassöffnung und einer Luftauslassöffnung auf, wobei der Luftkanal parallel zu der ersten Oberfläche des Wärmetauschers ausgebildet ist, so dass durch den Luftkanal ein zweiter Luftstrom entlang der ersten Oberfläche führbar ist. Mittels der Sensoreinheit kann mindestens eine Messgröße erfasst werden und die Lüftereinheit kann mittels der Kontrolleinheit abhängig von dieser mindestens einen erfassten Messgröße angesteuert werden. Eine der ersten Oberfläche des Wärmetauschers gegenüberliegende zweite Oberfläche des Wärmetauschers kann in wärmeleitendem Kontakt mit einem wärmeabgebenden Gerät angeordnet werden, wobei die Kühlvorrichtung auf ein Gehäuse des wärmeabgebenden Geräts aufsetzbar ist.

Die Erfindung ermöglicht es damit, eine Kühlvorrichtung bereitzustellen, die automatisch zwischen einem aktiven und einem passiven Kühlbetrieb umgeschaltet werden kann, z.B. abhängig von der aktuellen Temperatur der zu kühlenden Oberfläche. So kann beispielsweise die Lüftereinheit abgeschaltet werden, wenn der zweite, externe Luftstrom ausreicht, um die benötigte Kühlleistung zu erbringen. So können externe Bedingungen, wie beispielsweise Fahrtwind vorteilhaft genutzt werden, um eine effiziente Kühlung zu erzielen, ohne dass die Lüftereinheit ständig betrieben werden muss.

Dadurch ergeben sich insbesondere für den Einsatz der erfindungsgemäßen Kühlvorrichtung im Automobil die Vorteile, dass zu kühlende Geräte flexibler bezüglich des Einbauorts an einem Fahrzeug angeordnet werden können. So ist beispielsweise auch eine Anordnung im Bereich des Motorraums denkbar. Insbesondere zur Kühlung von Umfeldsensoren des Fahrzeugs, beispielsweise Lidar-Sensoren, die eine hohe Abwärme von beispielsweise bis zu 120W produzieren, ist die erfindungsgemäße Kühlvorrichtung vorteilhaft einsetzbar und erlaubt eine verbesserte und flexiblere Einsetzbarkeit derartiger Sensoren am Fahrzeug. Die erfindungsgemäße Kühlvorrichtung ist kompakt, modular und integriert sämtliche benötigten Bauteile.

Bevorzugt ist der Gehäuserahmen auf den Wärmetauscher aufgesetzt, dadurch ergibt sich ein kompakter und stabiler Aufbau der Kühlvorrichtung.

In einer bevorzugten Ausführung weist die erste Oberfläche des Wärmetauschers eine Mehrzahl von Kühlrippen auf, die insbesondere entlang des Luftkanals ausgerichtet sind. Damit wird die Kühlleistung weiter verbessert.

Bevorzugt weist die Sensoreinheit zumindest einen Temperatursensor auf. Als Messgröße wird durch die Sensoreinheit eine Temperatur des Wärmetauschers erfasst und die Lüftereinheit wird abhängig von der erfassten Temperatur angesteuert.

In einer möglichen Ausführung der Erfindung weist der Gehäuserahmen ein Material mit einer Wärmeleitfähigkeit von weniger als 15 W/mK auf. Damit wird vermieden, dass sich der Gehäuserahmen aufheizt und die Lüftereinheit und/oder die Kontrolleinheit durch Hitze beschädigt werden. Ferner sind derartige Materialien, beispielsweise Kunststoffe, oft leichter als Materialien mit höherer Wärmeleitfähigkeit.

Bevorzugt weist der Wärmetauscher ein Material mit einer Wärmeleitfähigkeit von mehr als 50 W/mK auf, um Wärme effektiv abzuleiten.

Durch den modularen Aufbau aus separatem Wärmetauscher und Gehäuserahmen können vorteilhaft unterschiedliche Materialen zum Aufbau der Kühlvorrichtung verwendet werden, so dass sich insgesamt ein im Vergleich zum Stand der Technik leichterer und preisgünstigerer Aufbau ergibt.

Nach einem zweiten Aspekt der Erfindung wird ein Verfahren zur Kühlung eines wärmeabgebenden Geräts, insbesondere eines Umfeldsensors eines Kraftfahrzeugs vorgeschlagen, bei dem eine wie oben beschrieben ausgeführte Kühlvorrichtung verwendet wird. Dabei wird mittels der Sensorvorrichtung mindestens eine Messgröße, insbesondere eine Temperatur und/oder eine Strömungsgeschwindigkeit, erfasst und die Lüftereinheit abhängig von der mindestens einen erfassten Messgröße angesteuert. Durch die Lüftereinheit wird somit ein erster Luftstrom erzeugt, der in Richtung der ersten Oberfläche des Wärmetauschers ausgerichtet ist. Im Fall einer Bewegung der Kühlvorrichtung in eine vorgegebene Richtung wird durch die Bewegung ein zweiter Luftstrom durch den Luftkanal erzeugt. Weiterhin ist eine der ersten Oberfläche des Wärmetauschers gegenüberliegende zweite Oberfläche des Wärmetauschers in wärmeleitendem Kontakt mit dem wärmeabgebenden Gerät angeordnet, wobei die Kühlvorrichtung auf ein Gehäuse des wärmeabgebenden Geräts aufgesetzt ist.

Nach einem weiteren Aspekt der Erfindung wird ein Fahrzeug vorgeschlagen. Das Fahrzeug weist ein an dem Fahrzeug angeordnetes, wärmeabgebendes Gerät auf, insbesondere einem Umfeldsensor, sowie eine erfindungsgemäß ausgebildete Kühlvorrichtung. Eine der ersten Oberfläche des Wärmetauschers der Kühlvorrichtung gegenüberliegende zweite Oberfläche des Wärmetauschers der Kühlvorrichtung ist in wärmeleitendem Kontakt mit dem wärmeabgebenden Gerät angeordnet. Die Kühlvorrichtung ist derart ausgerichtet, dass durch eine Vorwärtsbewegung des Fahrzeugs ein externer, zweiter Luftstrom durch den mindestens einen Luftkanal der Kühlvorrichtung erzeugt wird. Insbesondere kann der Wärmetauscher beispielsweise integral mit einem Gehäuse des wärmeabgebenden Geräts ausgebildet sein.

Die Kühlvorrichtung bzw. das wärmeabgebende Gerät, das sich in wärmeleitendem Kontakt mit dem Wärmetauscher der Kühlvorrichtung befindet, kann im Prinzip an einem beliebigen Ort an dem Fahrzeug angeordnet sein. Es ist lediglich notwendig, dass der Luftkanal bzw. die Luftkanäle in Richtung des Fahrtwindes bei Vorwärtsbewegung des Fahrzeugs ausgerichtet sind. Das wärmeabgebende Gerät und/oder die Kühlvorrichtung kann beispielsweise auf dem Dach des Fahrzeugs angeordnet sein. Das wärmeabgebende Gerät und/oder die Kühlvorrichtung kann beispielsweise im Bereich der Stoßstange an der Front des Fahrzeugs angeordnet sein. Das wärmeabgebende Gerät und/oder die Kühlvorrichtung kann dabei beispielsweise zumindest teilweise im Motorraum und oder in unmittelbarer Nähe zum Motorraum des Fahrzeugs angeordnet sein.

Die Kühlvorrichtung kann beispielsweise modular auf das Gehäuse des wärmeabgebenden Geräts aufgesetzt werden, wenn das wärmeabgebende Gerät in oder an dem Fahrzeug verbaut wird. Alternativ kann die Kühlvorrichtung mit dem wärmeabgebenden Gerät integral verbaut sein.

Das wärmeabgebende Gerät ist beispielsweise als ein Lidar-Sensor ausgebildet. Lidar-Sensoren werden bevorzugt zur Umfelderfassung insbesondere für autonome Fahrfunktionen und Fahrerassistenzfunktionen eingesetzt. Lidar-Sensoren implementieren üblicherweise einen oder mehrere Laserdioden, die in Verbindung mit ihren Treiberschaltungen üblicherweise eine hohe Abwärme erzeugen und gekühlt werden müssen.

Gemäß der Erfindung wird außerdem ein Umfeldsensor, insbesondere ein Lidar-Sensor, mit mindestens einer wie oben beschriebenen Kühlvorrichtung vorgeschlagen. In einer bevorzugten Ausführung weist der Lidar-Sensor mindestens zwei erfindungsgemäße Kühlvorrichtungen auf.

In einer bevorzugten Ausführung ist der Wärmetauscher in den Lidar-Sensor, insbesondere in ein Gehäuse des Lidar-Sensors, integriert und der Gehäuserahmen wird auf den Wärmetauscher aufgesetzt. Dies ist besonders vorteilhaft, da durch die direkte Anbindung und den dadurch geringen thermischen Widerstand das Kühlen des Lidar-Sensors sehr effizient gestaltet werden kann.

In einer alternativen Ausführung kann der Wärmetauscher separat ausgebildet sein und z.B. auf eine wärmeabgebende Außenfläche des Lidar-Sensors aufgesetzt sein.

Ein Lidar-Sensor weist üblicherweise ein Gehäuse auf, innerhalb dessen die Sensorelektronik und Optik aufgenommen sind. Das Gehäuse kann ein Messfenster umfassen, durch das Licht in die Umgebung gelangen kann und/oder reflektiertes Licht aus der Umgebung empfangen werden kann. Das Gehäuse kann gemäß der Erfindung eine oder mehrere erfindungsgemäß ausgebildete Kühlvorrichtungen aufweisen.

In einer alternativen Ausführung, kann der Lidar-Sensor derart ausgestaltet sein, dass eine Kameraeinheit, die den Empfänger des Lidar-Sensors darstellt und ein oder mehrere Illuminatoren, die ausgebildet sind, Licht in die Umgebung des Lidar-Sensors abzugeben, separat, insbesondere mit separaten Gehäusen, vorgesehen sind. Die Kameraeinheit und/oder der oder die Illuminatoren können zur Kühlung jeweils eine oder mehrere erfindungsgemäß ausgebildete Kühlvorrichtungen aufweisen.

Die Erfindung in all ihren Aspekten ermöglicht eine intelligente Kühllösung, die es erlaubt automatisch zwischen einem aktivem und einem passivem Kühlmodus umzuschalten und den aktiven Kühlmodus so zu regeln, dass stets die optimale Kühlleistung erzielt wird. So kann insbesondere, wenn ein ausreichender externer Luftstrom vorhanden ist, der aktive Kühlmodus deaktiviert werden.

### Kurze Beschreibung der Zeichnungen

Figur 1 zeigt eine mögliche Ausführung einer erfindungsgemäßen Kühlvorrichtung in Draufsicht
Figur 2 zeigt die Kühlvorrichtung gemäß Figur 1 in Schrägansicht
Figuren 3 a)-c) zeigen jeweils einen Schnitt durch die Kühlvorrichtung gemäß Figur 1, wobei verschiedene Betriebszustände der Kühlvorrichtung dargestellt sind.
Figur 4 zeigt ein Ablaufdiagramm eines Verfahrens zur Kühlung eines wärmeabgebenden Geräts gemäß einer möglichen Ausführung der Erfindung.
Figur 5 zeigt ein Fahrzeug mit einem Umfeldsensor und einer erfindungsgemäß ausgebildeten Kühlvorrichtung.
Figur 6 zeigt ein Ausführungsbeispiel eines erfindungsgemäß ausgestalteten Lidar-Sensors.

### Ausführungen der Erfindung

In der nachfolgenden Beschreibung der Ausführungsbeispiele der Erfindung werden gleiche Elemente mit gleichen Bezugszeichen bezeichnet, wobei auf eine wiederholte Beschreibung dieser Elemente gegebenenfalls verzichtet wird. Die Figuren stellen den Gegenstand der Erfindung nur schematisch dar.

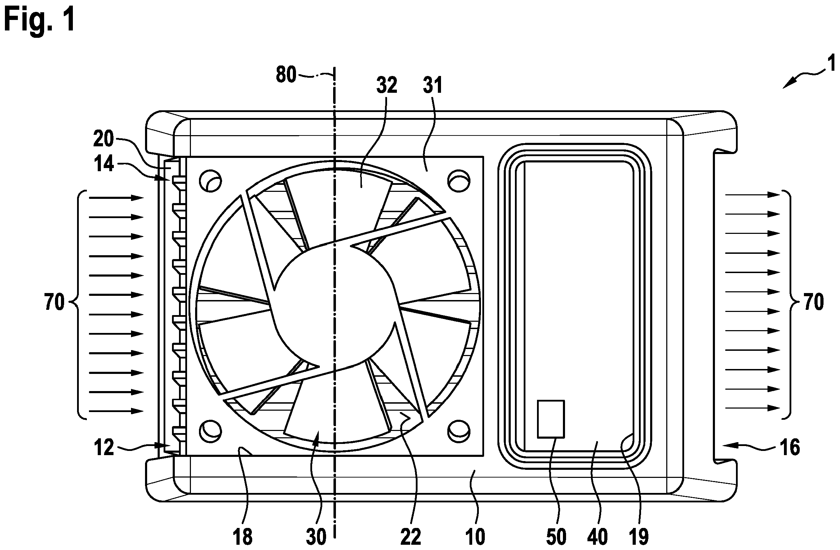

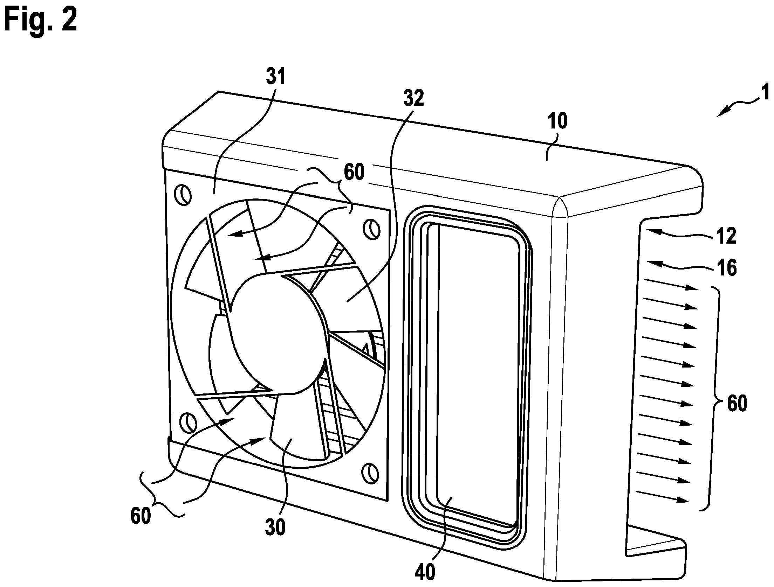

Ein mögliches Ausführungsbeispiel einer erfindungsgemäßen Kühlvorrichtung 1 ist in Figur 1 in Draufsicht dargestellt. Eine baugleiche Kühlvorrichtung 1 ist in Figur 2 in Schrägansicht dargestellt.

Die Kühlvorrichtung 1 umfasst einen Gehäuserahmen 10, der auf einen Wärmetauscher 20 aufgesetzt ist und diese teilweise seitlich überragt. Der Wärmetauscher 20 ist in diesem Beispiel in Form einer Kühlplatte ausgebildet und weist eine erste Oberfläche 22 auf die dem Gehäuserahmen 10 zugewandt ist. In dem Gehäuserahmen 10 sind eine elektrisch antreibbare Lüftereinheit 30 und eine Kontrolleinheit 40 aufgenommen, jeweils in Aussparungen 18, 19 des Gehäuserahmens 10. Die Lüftereinheit 30 ist derart angeordnet, dass, wenn die Lüftereinheit in Betrieb ist, ein erster Luftstrom 60 in Richtung der ersten Oberfläche 22 des Wärmetauschers 20 erzeugt wird. Die erste Oberfläche 22 des Wärmetauschers 20 ist in diesem Beispiel durch den Gehäuserahmen 10 überdeckt und weist eine Mehrzahl von Kühlrippen auf. Der Gehäuserahmen 10 weist auf einer Seite eine Lufteinlassöffnung 14 und auf einer gegenüberliegenden Seite eine Luftauslassöffnung 16 auf. So wird ein einen Luftkanal 12 ausgebildet, der parallel zu der ersten Oberfläche 22 des Wärmetauschers 20 verläuft. Durch den Luftkanal kann ein zweiter Luftstrom 70 entlang der ersten Oberfläche 22 geführt werden. Der zweite Luftstrom 70 wird auch als externer Luftstrom bezeichnet, da er nicht durch die Lüftereinheit 30 erzeugt wird, sondern beispielsweise durch eine Bewegung in eine Richtung, die der Richtung des Luftkanals 12 entspricht. Die Kühlvorrichtung 1 umfasst weiterhin eine Sensoreinheit 50, die mindestens eine Messgröße erfasst, beispielsweise die Temperatur des Wärmetauschers 20. Die Sensoreinheit 50 kann beispielsweise in die Kontrolleinheit 40 integriert sein oder separat an dem Wärmetauscher 20 angeordnet sein. Die Kontrolleinheit 40 ist ausgebildet, die Lüftereinheit 30 anzusteuern. Erfindungsgemäß wird die Lüftereinheit 30 mittels der Kontrolleinheit 40 abhängig von der mindestens einen durch die Sensoreinheit 50 erfassten Messgröße angesteuert. So kann die Lüftereinheit 30 beispielsweise nur dann in Betrieb gesetzt werden, wenn die Temperatur des Wärmetauschers 20 einen bestimmten Grenzwert übersteigt. Beispielsweise kann auch eine Drehzahl der Lüftereinheit abhängig von der Messgröße geregelt werden. Als Sensoreinheit 50 kann beispielsweise ein Thermoelement oder andere bekannte Sensoren zur Temperaturmessung eingesetzt werden.

Der Gehäuserahmen 10 umfasst bevorzugt ein Material mit einer vergleichsweise geringen Wärmeleitfähigkeit von insbesondere weniger als 15 W/Km, um Beschädigungen durch Überhitzung an der Lüftereinheit 30 und/oder der Kontrolleinheit 40 zu vermeiden und um Gewicht einzusparen. Ein solches Material kann beispielsweise ein Kunststoff, wie beispielsweise Polypropylen sein.

Der Wärmetauscher 20 umfasst bevorzugt ein Material mit einer vergleichsweise hohen Wärmeleitfähigkeit von insbesondere mehr als 50 W/Km, um effizient Wärme von einer zu kühlenden Oberfläche abzuführen. Ein solches Material kann beispielsweise ein Metall, wie zum Beispiel Aluminium oder Kupfer, oder eine spezielle Keramik oder eine Legierung sein. Bevorzugt wird die Kühleinrichtung 1 derart verbaut, dass eine der ersten Oberfläche 22 gegenüberliegende zweite Oberfläche 23 des Wärmetauschers 20 mit der zu kühlenden Oberfläche in thermischem Kontakt steht.

Die Lüftereinheit 30 ist bevorzugt derart in eine Aussparung 18 des Gehäuserahmens 10 aufgenommen, dass der Rahmen 31 der Lüftereinheit 30 parallel zur Richtung des externen Luftstroms 70 ausgerichtet. Damit wird vermieden, dass die Lüfterblätter 32 im Stillstand der Lüftereinheit 30 durch den externen Luftstrom 70 beschädigt werden.

Die Kontrolleinheit 40 ist bevorzugt in einer versiegelten Kammer innerhalb der Aussparung 19 des Gehäuserahmens angeordnet.

In Figur 2 ist schematisch der erste Luftstrom 60 gezeigt, der durch die Lüftereinheit 30 erzeugt wird und der in Richtung der ersten Oberfläche 22 des Wärmetauschers 20 ausgerichtet ist. Durch den Luftstrom 60 werden Turbulenzen im Bereich der ersten Oberfläche 22 erzeugt, die die Wärmedissipation verstärken. Der erste Luftstrom 60 kann beispielsweise durch die Luftauslassöffnung 16 des Gehäuserahmens 10 entweichen. Wenn kein externer Luftstrom 70 vorhanden ist, kann der erste Luftstrom 60 auch durch die Lufteinlassöffnung 14 des Gehäuserahmens 10 entweichen.

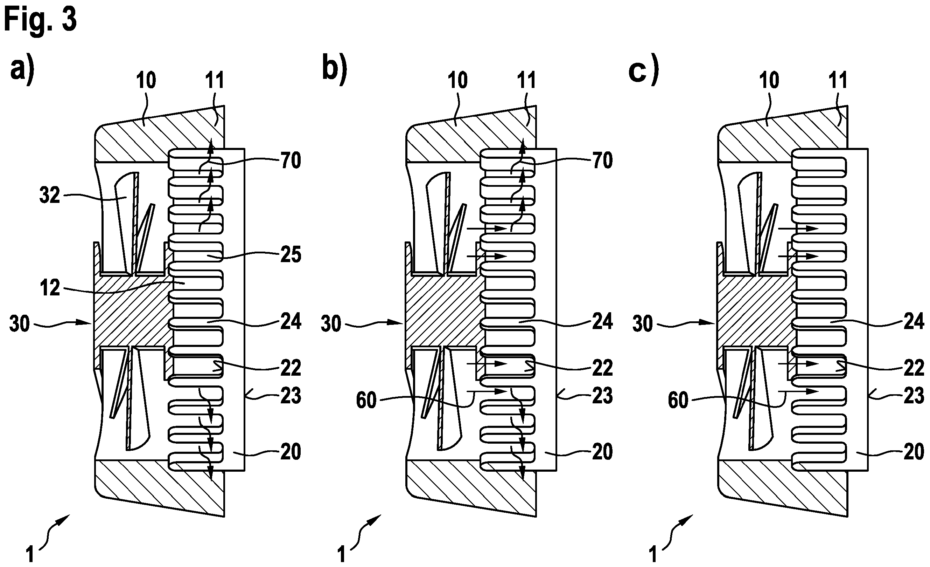

Figur 3 zeigt die Kühlvorrichtung 1 nach dem Ausführungsbeispiel der Figuren 1 und 2 im Schnitt wobei der Schnitt im Bereich der Lüftereinheit entlang der Schnittlinie 80 aus Figur 2 dargestellt ist. Hierbei wird deutlich, dass in diesem Ausführungsbeispiel der Gehäuserahmen 10 auf dem Wärmetauscher 20 angeordnet ist, indem der Gehäuserahmen 10 auf den Wärmetauscher 20, insbesondere auf die Kühlrippen 24 am Rand der Wärmetauscher 20 aufgesetzt ist. Der Gehäuserahmen weist dazu an zwei gegenüberliegenden Seiten Auskragungen 11 auf, so dass der Wärmetauscher 20 in den Gehäuserahmen 10 eingeschoben werden kann.

Figur 3 a) stellt einen ersten Betriebsmodus der Kühlvorrichtung 1 dar. In diesem ersten Betriebsmodus ist die Lüftereinheit 30 nicht Betrieb. Ein zweiter, externer Luftstrom 70, der beispielsweise durch eine Bewegung erzeugt wird, strömt durch den Luftkanal 12, der zwischen dem Gehäuserahmen 10 und der Wärmetauscher 20 ausgebildet ist, insbesondere verläuft der Luftstrom 70 in den Zwischenräumen 25 zwischen den Kühlrippen 24. Die Kühlleistung in diesem ersten Betriebsmodus hängt von den Eigenschaften des externen Luftstroms 70 ab. Dieser sogenannte passive Betriebszustand wird eingestellt, wenn der externe Luftstrom 70 ausreicht, um die gewünschte Kühlung des Wärmetauschers, insbesondere der ersten Oberfläche 22 und/oder der zweiten Oberfläche 23 zu erzielen.

Figur 3 b) stellt einen zweiten Betriebsmodus der Kühlvorrichtung 1 dar. In diesem zweiten Betriebsmodus ist die Lüftereinheit 30 zusätzlich in Betrieb. Durch die Lüftereinheit 30 wird ein erster Luftstrom 60, der auf die erste Oberfläche 22 des Wärmetauschers 20 gerichtet ist, erzeugt. Ein zweiter, externer Luftstrom 70, der beispielsweise durch eine Bewegung erzeugt wird, strömt zusätzlich durch den Luftkanal 12, der zwischen dem Gehäuserahmen 10 und der Wärmetauscher 20 ausgebildet ist. Der erste Luftstrom 60 ist im Wesentlichen orthogonal zu dem zweiten Luftstrom 70 gerichtet. Die Kühlleistung in diesem ersten Betriebsmodus hängt von den Eigenschaften des externen Luftstroms 70 sowie von dem durch die Lüftereinheit 30 erzeugten ersten Luftstrom 60 ab. Dieser zweite Betriebszustand wird eingestellt, wenn der externe Luftstrom 70 zwar vorhanden ist, aber alleine nicht ausreicht, um die gewünschte Kühlung des Wärmetauschers, insbesondere der ersten Oberfläche 22 und/oder der zweiten Oberfläche 23 zu erzielen. Die Lüftereinheit 30 wird mittels der Kontrolleinheit 40 entsprechend angesteuert, z.B. indem die Drehzahl angepasst wird. Die Regelung erfolgt abhängig von einer erfassten Messgröße, insbesondere der Temperatur des Wärmetauschers, insbesondere der ersten Oberfläche 22 und/oder der zweiten Oberfläche 23.

Figur 3 c) stellt einen dritten Betriebsmodus der Kühlvorrichtung 1 dar. In diesem zweiten Betriebsmodus ist kein bzw. nur ein vernachlässigbarer zweiter, externer Luftstrom vorhanden. Die Lüftereinheit 30 ist in Betrieb. Durch die Lüftereinheit 30 wird ein erster Luftstrom 60, der auf die erste Oberfläche 22 des Wärmetauschers 20 gerichtet ist, erzeugt. Die Kühlleistung in diesem ersten Betriebsmodus hängt von den Eigenschaften des durch die Lüftereinheit 30 erzeugten ersten Luftstroms 60 ab. Dieser dritte Betriebszustand wird eingestellt, wenn zum Beispiel bei Stillstand oder sehr langsamer Bewegung kein oder nur ein zu vernachlässigbarer externer Luftstrom vorhanden ist. Die Lüftereinheit 30 wird mittels der Kontrolleinheit 40 entsprechend angesteuert, z.B. indem die Drehzahl angepasst wird, dabei ist die Drehzahl im dritten Betriebsmodus insbesondere höher als in dem zweiten Betriebsmodus. Die Regelung erfolgt auch hier abhängig von einer erfassten Messgröße, insbesondere der Temperatur des Wärmetauschers, insbesondere der ersten Oberfläche 22 und/oder der zweiten Oberfläche 23.

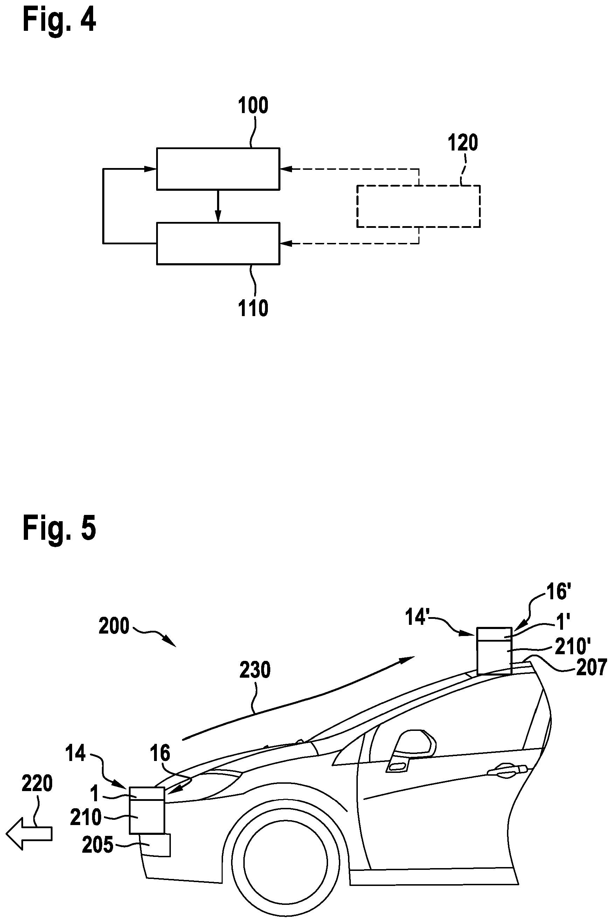

Figur 4 stellt ein Verfahren zur Kühlung eines wärmeabgebenden Geräts gemäß einer möglichen Ausführung der Erfindung schematisch als Ablaufdiagramm dar. Bei dem wärmeabgebenden Gerät kann es insbesondere um einen Umfeldsensors eines Kraftfahrzeugs, besonders bevorzugt einen Lidar-Sensor handelt. Das Verfahren verwendet zum Beispiel eine Kühlvorrichtung 1, die wie in den Figuren 1 bis 3 dargestellt ist, ausgebildet ist.

In einem ersten Verfahrensschritt 100 wird mittels der Sensorvorrichtung 50 der mindestens verwendeten Kühlvorrichtung 1 eine Messgröße, insbesondere eine Temperatur und/oder eine Strömungsgeschwindigkeit, erfasst. Beispielsweise wird die Oberflächentemperatur des Wärmetauschers 20 erfasst. Die Temperatur kann an der ersten Oberfläche 22 und/oder an der zweiten Oberfläche 23 des Wärmetauschers 20 erfasst werden.

Im folgenden Schritt 110 wird die Lüftereinheit 30 der Kühlvorrichtung 1 abhängig von der in Schritt 100 erfassten Messgröße angesteuert. Ergibt die Messung der Temperatur beispielsweise, dass die Messgröße, insbesondere eine erfasste Temperatur des Wärmetauschers 20 einen bestimmten ersten Schwellenwert überschreitet, so kann die Lüftereinheit 30 in Betrieb gesetzt werden und durch die Lüftereinheit 30 ein erster Luftstrom 60 erzeugt werden. Die Erfassung der Messgröße gemäß Schritt 100 wird fortlaufend weitergeführt. Wird über mehrere Messzyklen beispielsweise eine ansteigende Temperatur erfasst, so kann in Schritt 110 die Drehzahl der Lüftereinheit 30 gesteigert werden. Unterschreitet die in Schritt 100 erfasste Temperatur beispielsweise einen zweiten Schwellenwert, so kann die Lüftereinheit 30 in Schritt 110 deaktiviert werden.

Im Fall 120 einer Bewegung der Kühlvorrichtung 1 in eine vorgegebene Richtung wird ein zweiter Luftstrom 70 durch den Luftkanal 12 der Kühlvorrichtung 1 erzeugt.

Eine Bewegung 120 der Kühlvorrichtung 1 und der dadurch verursachte zweite Luftstrom 70 beeinflussen die in Schritt 100 erfasste Messgröße und damit auch die in Schritt 110 durchgeführte Ansteuerung der Lüftereinheit 30. Ist beispielsweise keine Bewegung 120 und damit zweiter Luftstrom 70 vorhanden, so kann eine in Schritt 100 erfasste Temperatur des Wärmetauschers 20 deutlich höher sein als in dem Fall, in dem ein signifikanter zweiter Luftstrom 70 vorhanden ist. In der Folge muss in Schritt 110 die Lüftereinheit 30 mit einer höheren Drehzahl betrieben werden, als wenn kein signifikanter zweiter Luftstrom 70 vorhanden ist. Ist hingegen ein zweiter Luftstrom 70 vorhanden, so muss die Lüftereinheit in Schritt 110 eventuell gar nicht oder nur mit einer geringen Drehzahl angesteuert werden.

In Figur 5 ist die Front eines Fahrzeugs 200 dargestellt, mit einem an dem Fahrzeug angeordneten wärmeabgebenden Gerät 210, das im Bereich der Stoßstange 205 des Fahrzeugs 210 angeordnet ist, insbesondere oberhalb der Stoßstange 205, z.B. mittig zwischen den Frontscheinwerfern. Bei dem Gerät 210 handelt es sich insbesondere einem Umfeldsensor wie z.B. einen Lidar-Sensor mit zugeordneter Leistungselektronik. Das Fahrzeug 200 weist weiterhin eine Kühlvorrichtung 1 auf, die beispielsweise so ausgebildet ist, wie im Zusammenhang mit den Figuren 1 bis 3 dargelegt wurde. Eine der erste Oberfläche 22 der Wärmetauscher 20 der Kühlvorrichtung 1 gegenüberliegende zweite Oberfläche 23 der Wärmetauscher 20 der Kühlvorrichtung 1 ist in wärmeleitendem Kontakt mit dem wärmeabgebenden Gerät 210 angeordnet wobei die Kühlvorrichtung 1 derart ausgerichtet ist, dass durch eine Vorwärtsbewegung des Fahrzeugs 200, angedeutet durch den Pfeil 220, eine Luftströmung 230 durch den mindestens einen Luftkanal 12 der Kühlvorrichtung 1 geleitet wird und so einen externen, zweiten Luftstrom 70 ausbildet. angeordnet. Bei der dargestellten Anordnung des Lidar-Sensors 210 im Bereich der Stoßstange 205, ist der Einsatz einer erfindungsgemäßen Kühlvorrichtung 1 besonders vorteilhaft, da der Lidar-Sensor der Abwärme des Motors ausgesetzt ist. Alternativ oder zusätzlich kann ein wärmeabgebendes Gerät 210' mit einer erfindungsgemäßen Kühlvorrichtung 1', z.B. ein weiterer oder alternativ angeordneter Lidar-Sensor, auch auf dem Dach 207 des Fahrzeugs 200 angeordnet sein. Die Kühlvorrichtung 1' ist ebenfalls derart ausgerichtet, dass durch eine Vorwärtsbewegung, des Fahrzeugs 200, die Luftströmung 230 durch den mindestens einen Luftkanal der Kühlvorrichtung 1' geleitet wird und so einen externen, zweiten Luftstrom 70 ausbildet. Weitere, alternative Anbringungsorte eines wärmeabgebenden Geräts mit einer erfindungsgemäßen Kühlvorrichtung an dem Fahrzeug 200 sind denkbar.

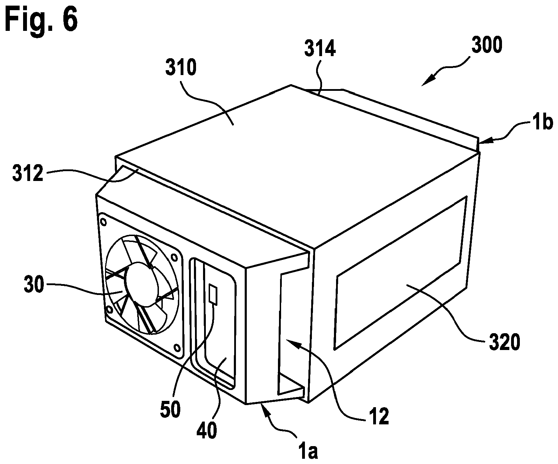

In Figur 6 ist ein Lidar-Sensor 300 gemäß einer möglichen Ausführung der Erfindung dargestellt. Der Lidar-Sensor 300 weist ein Gehäuse 310 auf, innerhalb dessen die Sensorelektronik und Optik aufgenommen sind, sowie ein Messfenster 320. Das Gehäuse 310 ist im Wesentlichen quaderförmig ausgebildet. Zwei Kühlvorrichtungen 1a und 1b sind an gegenüberliegenden Seitenflächen 312 und 314 des Gehäuses 310 angeordnet. Dabei bilden die Seitenflächen 312 und 314 die Wärmetauscher der Kühlvorrichtungen 1a und 1b aus. Die Kühlvorrichtungen 1a und 1b sind also integral mit dem Gehäuse 310 des Lidar-Sensors 300 ausgebildet. Die Kühlvorrichtungen 1a und 1b sind derart ausgerichtet, dass bei einer Bewegung des Lidar-Sensors 300 in eine vorgegebene Richtung jeweils ein externer Luftstrom 70 durch jede der Kühlvorrichtungen 1a, 1b erzeugt wird.

## Patentansprüche

1. Kühlvorrichtung (1), zumindest umfassend einen Gehäuserahmen (10), einen Wärmetauscher (20), eine elektrisch antreibbare Lüftereinheit (30), eine Kontrolleinheit (40) und eine Sensoreinheit (50), wobei die Lüftereinheit (30) derart angeordnet ist, dass bei Betrieb der Lüftereinheit (30) ein erster Luftstrom (60) in Richtung einer ersten Oberfläche (22) des Wärmetausches (20) erzeugt wird, wobei
der Gehäuserahmen (10) mindestens einen Luftkanal (12) mit einer Lufteinlassöffnung (14) und einer Luftauslassöffnung (16) aufweist, wobei der Luftkanal (12) parallel zu der ersten Oberfläche (22) der Wärmetauscher (20) ausgebildet ist, so dass durch den Luftkanal (12) ein zweiter Luftstrom (70) entlang der ersten Oberfläche (22) führbar ist,
wobei mittels der Sensoreinheit (50) mindestens eine Messgröße erfassbar ist und die Lüftereinheit (30) mittels der Kontrolleinheit (40) abhängig von der mindestens einen erfassten Messgröße ansteuerbar ist, **dadurch gekennzeichnet, dass** eine der ersten Oberfläche (22) des Wärmetauschers (20) gegenüberliegende zweite Oberfläche (23) des Wärmetauschers (20) ausgebildet ist, in wärmeleitendem Kontakt mit einem wärmeabgebenden Gerät (210, 210') angeordnet zu werden, wobei die Kühlvorrichtung auf ein Gehäuse des wärmeabgebenden Geräts aufsetzbar ist.

2. Kühlvorrichtung (1) nach Anspruch 1, **dadurch gekennzeichnet, dass** der Gehäuserahmen (10) mit dem Wärmetauscher (20) lösbar mechanisch verbunden ist.

3. Kühlvorrichtung (1) nach einem der Ansprüche 1 oder 2, **dadurch gekennzeichnet, dass** die Lüftereinheit (30) in einer Aussparung (18) des Gehäuserahmens (10) aufgenommen ist.

4. Kühlvorrichtung (1) nach einem der vorangehenden Ansprüche, **dadurch gekennzeichnet, dass** die erste Oberfläche (22) des Wärmetauschers (20) eine Mehrzahl von Kühlrippen (24) aufweist.

5. Kühlvorrichtung (1) nach Anspruch 4, **dadurch gekennzeichnet, dass** die Kühlrippen (24) entlang des Luftkanals (12) ausgerichtet sind.

6. Kühlvorrichtung (1) nach einem der vorangehenden Ansprüche, **dadurch gekennzeichnet, dass** die Sensoreinheit (50) zumindest einen Temperatursensor aufweist.

7. Kühlvorrichtung nach Anspruch 6, **dadurch gekennzeichnet, dass** als Messgröße durch die Sensoreinheit (50) eine Temperatur des Wärmetauschers (20) oder einer zu kühlenden Oberfläche erfassbar ist.

8. Kühlvorrichtung nach einem der vorangehenden Ansprüche, **dadurch gekennzeichnet, dass** der Gehäuserahmen (10) ein Material mit einer Wärmeleitfähigkeit von weniger als 15 W/mK aufweist.

9. Kühlvorrichtung nach einem der vorangehenden Ansprüche, **dadurch gekennzeichnet, dass** der Wärmetauscher (20) ein Material mit einer Wärmeleitfähigkeit von mehr als 50 W/mK aufweist.

10. Verfahren zur Kühlung eines wärmeabgebenden Geräts (210), insbesondere eines Umfeldsensors (300) eines Kraftfahrzeugs (200), unter Verwendung einer Kühlvorrichtung (1) nach einem der Ansprüche 1 bis 9, wobei
- mittels der Sensorvorrichtung (50) mindestens eine Messgröße, insbesondere eine Temperatur und/oder eine Strömungsgeschwindigkeit, erfasst wird,
- die Lüftereinheit (30) abhängig von der mindestens einen erfassten Messgröße angesteuert wird und durch die Lüftereinheit (30) ein erster Luftstrom (60) erzeugt wird,
- im Fall einer Bewegung der Kühlvorrichtung in eine vorgegebene Richtung (220), ein zweiter Luftstrom (230, 70) durch den Luftkanal (12) erzeugt wird **dadurch gekennzeichnet, dass** eine der ersten Oberfläche (22) des Wärmetauschers (20) gegenüberliegende zweite Oberfläche (23) des Wärmetauschers (20) in wärmeleitendem Kontakt mit dem wärmeabgebenden Gerät (210, 210') angeordnet ist, wobei die Kühlvorrichtung auf ein Gehäuse des wärmeabgebenden Geräts aufgesetzt ist.

11. Fahrzeug (200) mit mindestens einem an dem Fahrzeug angeordneten wärmeabgebenden Gerät (210, 210'), insbesondere einem Umfeldsensor (300), und mindestens einer Kühlvorrichtung (1, 1') gemäß einem der Ansprüche 1 bis 8, wobei eine der ersten Oberfläche (22) des Wärmetauschers (20) der Kühlvorrichtung (1, 1') gegenüberliegende zweite Oberfläche (23) des Wärmetauschers (20) der Kühlvorrichtung (1) in wärmeleitendem Kontakt mit dem wärmeabgebenden Gerät (210, 210') angeordnet ist, und wobei die Kühlvorrichtung (1,1') derart ausgerichtet ist, dass durch eine Vorwärtsbewegung des Fahrzeugs (200) ein externer, zweiter Luftstrom (230, 70) durch den mindestens einen Luftkanal (12) der Kühlvorrichtung (1, 1') erzeugt wird.

12. Fahrzeug (200) nach Anspruch 11, **dadurch gekennzeichnet, dass** das wärmeabgebende Gerät (210, 210') als ein Lidar-Sensor ausgebildet ist.

13. Fahrzeug nach einem der Ansprüche 11 oder 12, **dadurch gekennzeichnet, dass** ein wärmeabgebendes Gerät (210) an der Fahrzeugfront, insbesondere im Bereich der Stoßstange (205) des Fahrzeugs (200), oder auf dem Dach (207) des Fahrzeugs (200) angeordnet ist.

14. Umfeldsensor (300), insbesondere Lidar-Sensor, insbesondere zum Einsatz in einem Fahrzeug (200), mit mindestens einer Kühlvorrichtung (1a, 1b) nach einem der Ansprüche 1 bis 9.

## Claims

1. Cooling apparatus (1), at least comprising a housing frame (10), a heat exchanger (20), an electrically driveable fan unit (30), a control unit (40) and a sensor unit (50), wherein the fan unit (30) is arranged in such a way that, when the fan unit (30) is in operation, there is generated a first air stream (60) in the direction of a first surface (22) of the heat exchanger (20), wherein the housing frame (10) has at least one air channel (12) with an air-inlet opening (14) and with an air-outlet opening (16), wherein the air channel (12) is formed so as to be parallel to the first surface (22) of the heat exchanger (20), so that, through the air channel (12), it is possible for there to be conducted a second air stream (70) along the first surface (22),
wherein at least one measurement variable is detectable by means of the sensor unit (50) and the fan unit (30) is controllable by means of the control unit (40) according to the at least one detected measurement variable, **characterized in that** a second surface (23) of the heat exchanger (20), which is situated opposite the first surface (22) of the heat exchanger (20), is configured to be arranged in thermally conductive contact with a heat-emitting device (210, 210'), wherein the cooling apparatus is mountable onto a housing of the heat-emitting device.

2. Cooling apparatus (1) according to Claim 1, **characterized in that** the housing frame (10) is releasably mechanically connected to the heat exchanger (20) .

3. Cooling apparatus (1) according to either of Claims 1 and 2, **characterized in that** the fan unit (30) is accommodated in a cutout (18) of the housing frame (10).

4. Cooling apparatus (1) according to one of the preceding claims, **characterized in that** the first surface (22) of the heat exchanger (20) has a plurality of cooling ribs (24).

5. Cooling apparatus (1) according to Claim 4, **characterized in that** the cooling ribs (24) are oriented along the air channel (12).

6. Cooling apparatus (1) according to one of the preceding claims, **characterized in that** the sensor unit (50) has at least a temperature sensor.

7. Cooling apparatus according to Claim 6, **characterized in that** a temperature of the heat exchanger (20) or of a surface to be cooled is detectable by the sensor unit (50) as measurement variable.

8. Cooling apparatus according to one of the preceding claims, **characterized in that** the housing frame (10) comprises a material with a thermal conductivity of less than 15 W/mK.

9. Cooling apparatus according to one of the preceding claims, **characterized in that** the heat exchanger (20) comprises a material with a thermal conductivity of greater than 50 W/mK.

10. Method for cooling a heat-emitting device (210), in particular a surroundings sensor (300) of a motor vehicle (200), using a cooling apparatus (1) according to one of Claims 1 to 9, wherein
- at least one measurement variable, in particular a temperature and/or a flow speed, is detected by means of the sensor unit (50),
- the fan unit (30) is controlled according to the at least one detected measurement variable and a first air stream (60) is generated by the fan unit (30),
- in the case of a movement of the cooling apparatus in a predefined direction (220), there is generated a second air stream (230, 70) through the air channel (12), **characterized in that** a second surface (23) of the heat exchanger (20), which is situated opposite the first surface (22) of the heat exchanger (20), is arranged in thermally conductive contact with a heat-emitting device (210, 210'), wherein the cooling apparatus is mountable onto a housing of the heat-emitting device.

11. Vehicle (200) having at least one heat-emitting device (210, 210'), in particular a surroundings sensor (300), which is arranged on the vehicle, and having at least one cooling apparatus (1, 1`) according to one of Claims 1 to 8, wherein a second surface (23) of the heat exchanger (20) of the cooling apparatus (1), which is situated opposite the first surface (22) of the heat exchanger (20) of the cooling apparatus (1, 1'), is arranged in thermally conductive contact with the heat-emitting device (210, 210'), and wherein the cooling apparatus (1, 1') is oriented in such a way that a forward movement of the vehicle (200) generates an external, second air stream (230, 70) through the at least one air channel (12) of the cooling apparatus (1, 1').

12. Vehicle (200) according to Claim 11, **characterized in that** the heat-emitting device (210, 210') is designed as a lidar sensor.

13. Vehicle according to either of Claims 11 and 12, **characterized in that** a heat-emitting device (210) is arranged on the front of the vehicle, in particular in the region of the bumper (205) of the vehicle (200), or on the roof (207) of the vehicle (200).

14. Surroundings sensor (300), in particular lidar sensor, in particular for use in a vehicle (200), having at least one cooling apparatus (1a, 1b) according to one of Claims 1 to 9.

## Revendications

1. Dispositif de refroidissement (1) comprenant au moins un cadre de boîtier (10), un échangeur de chaleur (20), une unité de ventilateur (30) pouvant être entraînée électriquement, une unité de commande (40) et une unité de capteur (50), l'unité de ventilateur (30) étant agencée de telle sorte que, lors du fonctionnement de l'unité de ventilateur (30), un premier courant d'air (60) est généré en direction d'une première surface (22) de l'échangeur de chaleur (20),
le cadre de boîtier (10) présentant au moins un canal d'air (12) avec une ouverture d'entrée d'air (14) et une ouverture de sortie d'air (16), le canal d'air (12) étant réalisé parallèlement à la première surface (22) de l'échangeur de chaleur (20), de telle sorte qu'un deuxième courant d'air (70) peut être guidé à travers le canal d'air (12) le long de la première surface (22),
au moins une grandeur de mesure pouvant être détectée au moyen de l'unité de capteur (50) et l'unité de ventilateur (30) pouvant être commandée au moyen de l'unité de commande (40) en fonction de l'au moins une grandeur de mesure détectée, **caractérisé en ce qu'**une deuxième surface (23) de l'échangeur de chaleur (20), opposée à la première surface (22) de l'échangeur de chaleur (20), est réalisée pour être agencée en contact de conduction thermique avec un appareil (210, 210') émettant de la chaleur, le dispositif de refroidissement pouvant être monté sur un boîtier de l'appareil émettant de la chaleur.

2. Dispositif de refroidissement (1) selon la revendication 1, **caractérisé en ce que** le cadre de boîtier (10) est relié mécaniquement de manière amovible à l'échangeur de chaleur (20).

3. Dispositif de refroidissement (1) selon l'une quelconque des revendications 1 ou 2, **caractérisé en ce que** l'unité de ventilateur (30) est reçue dans un évidement (18) du cadre de boîtier (10).

4. Dispositif de refroidissement (1) selon l'une quelconque des revendications précédentes, **caractérisé en ce que** la première surface (22) de l'échangeur de chaleur (20) présente une pluralité de nervures de refroidissement (24).

5. Dispositif de refroidissement (1) selon la revendication 4, **caractérisé en ce que** les nervures de refroidissement (24) sont orientées le long du canal d'air (12).

6. Dispositif de refroidissement (1) selon l'une quelconque des revendications précédentes, **caractérisé en ce que** l'unité de capteur (50) présente au moins un capteur de température.

7. Dispositif de refroidissement selon la revendication 6, **caractérisé en ce qu'**une température de l'échangeur de chaleur (20) ou d'une surface à refroidir peut être détectée en tant que grandeur de mesure par l'unité de capteur (50).

8. Dispositif de refroidissement selon l'une quelconque des revendications précédentes, **caractérisé en ce que** le cadre de boîtier (10) présente un matériau ayant une conductivité thermique inférieure à 15 W/mK.

9. Dispositif de refroidissement selon l'une quelconque des revendications précédentes, **caractérisé en ce que** l'échangeur de chaleur (20) présente un matériau ayant une conductivité thermique supérieure à 50 W/mK.

10. Procédé de refroidissement d'un appareil (210) émettant de la chaleur, notamment d'un capteur d'environnement (300) d'un véhicule automobile (200), utilisant un dispositif de refroidissement (1) selon l'une quelconque des revendications 1 à 9,
- au moins une grandeur de mesure, notamment une température et/ou une vitesse d'écoulement, étant détectée au moyen du dispositif de capteur (50),
- l'unité de ventilateur (30) étant commandée en fonction de l'au moins une grandeur de mesure détectée et un premier courant d'air (60) étant généré par l'unité de ventilateur (30),
- dans le cas d'un déplacement du dispositif de refroidissement dans une direction prédéterminée (220), un deuxième courant d'air (230, 70) étant généré à travers le canal d'air (12), **caractérisé en ce qu'**une deuxième surface (23) de l'échangeur de chaleur (20), opposée à la première surface (22) de l'échangeur de chaleur (20), est agencée en contact de conduction thermique avec l'appareil (210, 210') émettant de la chaleur, le dispositif de refroidissement étant monté sur un boîtier de l'appareil émettant de la chaleur.

11. Véhicule (200) avec au moins un appareil émetteur de chaleur (210, 210') agencé sur le véhicule, notamment un capteur d'environnement (300), et au moins un dispositif de refroidissement (1, 1') selon l'une quelconque des revendications 1 à 8, une deuxième surface (23) de l'échangeur de chaleur (20) du dispositif de refroidissement (1, 1'), opposée à la première surface (22), étant agencée en contact de conduction thermique avec l'appareil (210, 210') émettant de la chaleur, et le dispositif de refroidissement (1, 1') étant orienté de telle sorte qu'un déplacement vers l'avant du véhicule (200) génère un deuxième courant d'air externe (230, 70) à travers l'au moins un canal d'air (12) du dispositif de refroidissement (1, 1').

12. Véhicule (200) selon la revendication 11, **caractérisé en ce que** l'appareil (210, 210') émettant de la chaleur est réalisé sous la forme d'un capteur lidar.

13. Véhicule selon l'une quelconque des revendications 11 ou 12, **caractérisé en ce qu'**un appareil (210) émettant de la chaleur est agencé à l'avant du véhicule, notamment dans la zone du pare-chocs (205) du véhicule (200), ou sur le toit (207) du véhicule (200).

14. Capteur d'environnement (300), notamment capteur lidar, notamment destiné à être utilisé dans un véhicule (200), avec au moins un dispositif de refroidissement (1a, 1b) selon l'une quelconque des revendications 1 à 9.
